# EUROPEAN PATENT APPLICATION

(11) **EP 2 879 185 A1**
(43) Date of publication of application: **03.06.2015**
(21) Application number: 13195174.1
(22) Date of filing: 29.11.2013
(51) Int. Cl.: H01L 29/78, H01L 21/336

(54) **Radio frequency power transistor with a resistor region between a source and a drain contact region and method for manufacturing such a transistor**

(71) Applicant: NXP B.V., 5656 AG Eindhoven (NL)
(72) Inventor: De Boet, Johannes Adrianus Maria, 5656 AG Eindhoven (NL)

(57) **Abstract**

In this document there is described a Radio Frequency power transistor device (200b, 400b) which comprises (a) a substrate (110), (b) a source contact region (120) formed over the substrate (110), (c) a gate contact region formed (140) over the substrate (110), (d) a drain contact region (130) formed over the substrate (110), (e) a parasitic bipolar transistor (160) given between the substrate (110) and the gate contact region (140), (f) an elongated drain extension region (134) being connected to the drain contact region (130) and extending at least partially towards the parasitic bipolar transistor (160), and (g) an elongated resistor region (270, 470) being arranged between the source contact region (120) and the drain contact region (130). The elongated resistor region (270, 470) extends partially between the source contact region (120) and the drain contact region (130). It is further described a method for forming such a power transistor device (200b, 400b).

## Description

### FIELD OF THE INVENTION

The present invention relates to the technical field of semiconductor devices. In particular, the present invention relates to a Radio Frequency power transistor device such as a Radio Frequency Laterally Diffused Metal Oxide Semiconductor device. Further, the present invention relates to a method for manufacturing such a Radio Frequency power transistor device.

### BACKGROUND OF THE INVENTION

Radio Frequency (RF) Laterally Diffused Metal Oxide Semiconductor (LDMOS) is currently the dominant electronic device technology used in high-power RF Power Amplifier (PA) applications for frequencies ranging from 1 MHz to greater than 3.5 GHz and a power handling of e.g. several 100 Watts. Beginning in the early 1990s, LDMOS devices have gained wide acceptance for cellular infrastructure PA applications. Nowadays, LDMOS is the dominant RF power device technology being used for the infrastructure cellular telecommunication networks. This device technology offers significant advantages over the previous incumbent device technology, the silicon bipolar transistor, providing superior linearity, efficiency, gain and lower cost packaging options.

Voltage Standing Wave Ratio (VSWR) ruggedness is an important aspect for power RF LDMOS transistors or devices. This VSWR ruggedness can be defined as the ability to withstand reflected power at the output of a RF LDMOS device. In accordance with basic principles of high frequency technology power is reflected if an impedance mismatch occurs. This can occur as an incident (e.g. breaking of an antenna) or as a structural, normal part of the application (e.g. switching on a lamp or laser, or undefined loading in a magnetron oven). Anyway, the reflected power is causing voltage peaks at the output (i.e. the drain) of the LDMOS device. If these voltage peaks becomes too high, the LDMOS device is destroyed.

The amount of reflected power a LDMOS device can withstand is expressed in the VSWR the LDMOS device can survive. A typical number for the VSWR is 1:10. However for several applications in the Industrial, Scientific, Medical (ISM) frequency band it is not sufficient if a LDMOS device can withstand a VSWR of 1:10. Often, a VSWR in the regime of 1:50 is present. With a VSWR of 1:50 almost all power (i.e. 96%) is reflected back into the LDMOS device. The company NXP had developed a series of LDMOS devices for this market, which are characterized by an extreme high ruggedness with respect to reflected power. This series of products is called XR (eXtreme Ruggedness).

Apart from the voltage peaks at the drain of a LDMOS device there is another technical issue. If no RF power can be delivered to a load (antenna) and almost all power is reflected back into the system, high dissipation within the LDMOS device will occur and, as a consequence, thermal problems will arise. In this respect it is mentioned that in practice the power levels can be very high. For example the LDMOS device BLF178XR provided by the company NXP can deliver a RF power of 1.4 kW. Therefore, if a high VSWR conditions occurs, a feedback loop must be made in order to reduce the generated RF power.

It is known to protect a RF power transistor device and in particular a LDMOS device against VSWR mismatch by using a so called electric circulator at the output (i.e. the drain) of the device. A circulator is a known passive and non-reciprocal three- or four-port electric device, in which a RF signal entering any port is transmitted only to the next port in rotation. A port in this context is a point where an external transmission line (such as a coaxial cable) connects to the electric device. For a three-port circulator, a signal applied to port 1 only comes out of port 2; a signal applied to port 2 only comes out of port 3; a signal applied to port 3 only comes out of port 1. Also using such a circulator is an effective solution how to prevent a reflection of a power signal into the output of a RF power transistor device, such a solution is very expensive.

There may be a need for providing a RF power transistor device which can be fabricated in a simple and effective manner and which in operation comprises a high ruggedness against a VSWR mismatch.

### OBJECT AND SUMMARY OF THE INVENTION

This need may be met by the subject matter according to the independent claims. Advantageous embodiments of the present invention are described by the dependent claims.

According to a first aspect of the invention there is provided a Radio Frequency power transistor device comprising (a) a substrate, (b) a source contact region formed over the substrate, (c) a gate contact region formed over the substrate, (d) a drain contact region formed over the substrate, (e) a parasitic bipolar transistor given between the substrate and the gate contact region, (f) an elongated drain extension region being connected to the drain contact region and extending at least partially towards the parasitic bipolar transistor, and (g) an elongated resistor region being arranged between the source contact region and the drain contact region, wherein the elongated resistor region extends partially between the source contact region and the drain contact region.

The described Radio Frequency (RF) power transistor device is based on the idea that by adding an elongated resistor region to the design of a know RF power transistor device a spatial spreading or widening of the current density within the RF power transistor device and in particular between the source contact region and the drain contact region can be realized. As a consequence, a current crowding at one location within the described RF power transistor device can be avoided. This decreases effectively the sensitivity of the RF power transistor device with respect to a irreversible damaging in case the parasitic bipolar transistor will be triggered in particular due to high electric field being present in the RF power transistor device e.g. in response to a VSWR-ruggedness event. Such a VSWR-ruggedness event can arise e.g. if there is a mismatch of the wave resistance or of the cable impedance at the output side of the RF power transistor device.

In this respect it is mentioned that a triggering of the parasitic bipolar transistor may result in a so called snapback characteristic which can be best seen in a voltage - current diagram where at the axis of abscissa the Drain-Source Voltage of the RF power transistor device is plotted and at the axis of ordinate the Drain-Source Current of the RF power transistor device is plotted. However, as mentioned above, with the configuration of the RF power transistor device described in this document, which configuration comprises the elongated resistor region acting as a current spreading resistor, the sensitiveness of the power transistor device in response to a snapback event can be effectively and significantly reduced.

According to an embodiment of the invention the elongated resistor region comprises a sheet resistance of less than 400 Ohm/square, preferably of less than 300 Ohm/square and more preferably less than 200 Ohm/square.

According to a further embodiment of the invention the Radio Frequency power transistor device further comprises a connection region extending between the substrate and the source contact region.

Providing such a connection region may give the advantage that a bottom side of the described RF power transistor device will be connected to the source contact region. Thus, the described RF power transistor device can be connected with external voltage levels in the same way as known RF power transistor devices. Therefore, the described RF power transistor device can be used in RF power amplifiers instead of usual RF power transistor devices without changing the electric circuitry of the RF power amplifier. As indicated above, a RF power amplifier comprising at least one RF power transistor device as described in this document will have a decreased sensitivity for damages in response to VSWR-ruggedness events.

The described connection region may be realized in particular by means of a doped material. In case of a p-type doping the connection region may be denominated descriptively a P-sinker region.

According to a further embodiment of the invention the Radio Frequency power transistor device further comprises a base zone being formed between the gate contact region and the substrate, wherein the base zone is assigned to the parasitic transistor.

The base zone may preferably also be realized by means of a doped region. In case the RF power transistor device comprises the above mentioned connection region respectively P-sinker region, the base zone may also connect to the connection region respectively the P-sinker region.

According to a further embodiment of the invention the Radio Frequency power transistor device further comprises an oxide layer formed over at least the gate contact region. This may provide the advantage that the described RF power transistor device will be effectively protected against negative external influences which may impinge from the top of the device. Specifically, the sensitive region of the described RF power transistor device, which typically is the region of and around the gate contact region, may be protected from humidity, mechanical stress and/or contamination.

According to a further embodiment of the invention the Radio Frequency power transistor device further comprises a shield arrangement, which is formed within the oxide layer and which is configured for shielding an electric field acting on the gate contact region.

Shielding the gate contact region from a comparatively strong electric field which may extend in particular between the drain contact region and the gate contact region if these regions are at a different voltage level may provide the advantage that electrons "of", "at", or "within" the gate contact region are prevented from entering the oxide layer. As a consequence, an electric charging of the oxide layer can be effectively prevented.

The shield arrangement can comprise one, two, three, or even more shield elements. The at least one shield element may be preferably formed out of a metallic material, which with respect to the used semiconductor processing scheme of the described RF power transistor device should be compatible with the material of the oxide layer.

According to a further embodiment of the invention the source contact region, the gate contact region and/or the drain contact region comprise a metallic material.

Preferably, the source contact region and/or drain contact region are realized by means of a metallization stack. During processing or manufacturing the described RF power transistor device such metallization stack(s) may be formed in a known manner e.g. by depositing a metallic material by means of a known deposition procedure. Thereby, the metallization stack may comprise only one type of metal or a selection of a plurality of several types of metall.

In this respect it is mentioned that also the gate contact region may be electrically connected with a metallization which may comprise one or more types of metall.

It is further mentioned that with respect to the used semiconductor processing scheme of the described RF power transistor device the metallic material should be compatible with the other semiconductor materials used for building up the described RF power transistor device.

According to a further embodiment of the invention the Radio Frequency power transistor device further comprises (a) a source transition region connecting the source contact region with the parasitic bipolar transistor and (b) a drain transition region connecting the drain contact region with the elongated drain extension region, wherein both the source transition region and the drain transition region are doped regions. This may provide the advantage that a reliable contact between (i) each one of the two contact regions and (b) the parasitic bipolar transistor respectively the elongated drain extension region can be realized in view of the matter of fact that both the parasitic bipolar transistor and the elongated drain extension region are made by respectively realized within a semiconductor material.

According to a further embodiment of the invention the elongated resistor region (i) is formed between the drain contact region and the parasitic bipolar transistor and (ii) is arranged adjacent to the elongated drain extension region, wherein with respect to their longitudinal axes the elongated resistor region and the elongated drain extension region are arranged at least approximately parallel to each other.

Providing the elongated resistor region below and/or on top of the elongated drain extension region a spatial spreading or widening of the current density within the RF power transistor device and in particular between the parasitic bipolar transistor and the drain contact region can be realized. As a consequence, a current crowding at one location between the parasitic bipolar transistor and the drain contact of the RF power transistor device can be avoided. This decreases effectively the sensitivity of the RF power transistor device with respect to a irreversible damaging in case the parasitic bipolar transistor has been triggered in particular due to high electric field being present in the RF power transistor device e.g. in response to a VSWR-ruggedness event.

According to a further embodiment of the invention both the elongated drain extension region and the elongated resistor region are doped regions of the same type of doping, wherein the level of doping of the elongated resistor region is larger than the level of doping of the elongated drain extension region. This may provide the advantage that in particular in case of a VSWR-ruggedness event yielding to a high current between the parasitic bipolar transistor and the drain contact region the spatial extend of the yielded current will be increased such the overall current density will be reduced.

The type of doping of the elongated drain extension region and of the elongated resistor region may be a n-type doping. This may provide the advantage that for building up the described RF power transistor device a usual processing scheme can be used because with respect to the type of doping the type of the described RF power transistor device is the same as the type of known RF power transistor devices which however do not comprise the described elongated resistor region being formed at the elongated drain extension region.

According to a further embodiment of the invention a length of the elongated resistor region is at least 10%, preferably at least 15%, and more preferably at least 20% of the distance between the drain contact region and the gate contact region.

According to a further embodiment of the invention the elongated resistor region has a length of between 0.5 µm and 15 µm, preferably between1 µm and 12 µm, and more preferably between 1.5 µm and 11 µm. In particular the absolute length of the elongated resistor region may be at least approximately 9.5 µm.

In this respect it is mentioned that presently the above mentioned values seem to be appropriate in particular for LDMOS devices designed for a supply voltage of 50 V. In this case an elongated resistor region respectively a spreading resistor having a length of 9.5 µm works out. However, the same principle can be used for LDMOS devices designed for a supply voltage of 28 V. Here the drain extension is typically much smaller, which also holds for the spreading resistor. The height of the spreading resistor is not critical, however, if the spreading resistor is diffused deeper into the semiconductor material then the contact resistor of the drain, this can decrease the Breakdown Voltage BVds between Drain and Source of the respective RF-LDMOS device.

The spatial dimension can be alternatively or in combination described with respect to the spatial dimension of the elongated drain extension region. In this respect the ratio between (i) the length of the elongated resistor region and (ii) the length of the elongated drain extension region may be between 2/10 and 8/10, preferably between 3/10 and 7/10, and more preferably between 5/10 and 7/10. In particular this ratio may be at least approximately 2/3.

With respect to the length of the elongated resistor region it is pointed out that the optimal length of this region highly depends on the semiconductor manufacturing processes (in particular diffusion processes) being used for fabrication the described RF power transistor device.

According to a further embodiment of the invention the elongated resistor region (i) is formed between the source contact region and the parasitic bipolar transistor and (ii) is arranged adjacent to the source transition region.

In case also the source transition region has an elongated shape, with respect to their longitudinal axes the elongated resistor region and the elongated drain extension region are preferably arranged at least approximately parallel to each other.

In this respect it is mentioned that the embodiment described here where the elongated resistor region is formed between the source contact region and the parasitic bipolar transistor can also be combined with the embodiment described above where the resistor region is formed between the drain contact region and the parasitic bipolar transistor. In case of such a structural combination the elongated resistor region comprises two parts or portions being spatially separated from each other by the parasitic bipolar transistor.

According to a further embodiment of the invention the elongated resistor region has a length of between 0.5 µm and 15 µm, preferably between 1 µm and 12 µm, and more preferably between 1.5 µm and 11 µm. In particular the absolute length of the elongated resistor region may be at least approximately 9.5 µm.

The spatial dimension can be alternatively or in combination described with respect to the spatial dimension of the source transition region. In this respect the ratio between (i) the length of the elongated resistor region and (ii) the length of the source transition region may be between 1/2 and 1/1, preferably between 3/4 and 1/1, and more preferably between 4/5 and 1/1. In particular this ratio may be at least approximately 19/20.

With respect to the length of the elongated resistor region it is again pointed out that also for this embodiment the optimal length of this region highly depends on the semiconductor manufacturing processes (in particular diffusion processes) being used for fabrication the described RF power transistor device.

According to a further aspect of the invention there is provided a method for manufacturing a Radio Frequency power transistor device, in particular for manufacturing a Radio Frequency power transistor device as described above. The provided method comprises (a) providing a substrate, (b) forming over the substrate (i) a source contact region, (ii) a gate contact region, and (iii) a drain contact region such that a parasitic bipolar transistor is given between the substrate and the gate contact region, (c) forming an elongated drain extension region being connected to the drain contact region and extending at least partially towards the parasitic bipolar transistor, and (d) forming an elongated resistor region being arranged between the source contact region and the drain contact region, wherein the elongated resistor region extends partially between the source contact region and the drain contact region.

The described method is based on the idea that with a known semiconductor processing scheme the improved RF power transistor device described above can be fabricated. In particular, the semiconductor processing scheme for fabricating the device may include some diffusion processes, with which in particular the source transition region, the drain transition region, the base zone (of the parasitic bipolar transistor) being located adjacent to the gate contact region, the elongated drain extension region and/or the elongated resistor region can be formed.

The following regions, layers, or zones may be made of a semiconductor material. According to a preferred embodiment they have the following doping:
- Substrate: P-doping
- Connection region or P-sinker: P-doping
- Base zone: P-doping (P-well)
- Source transition region: n+ doping
- Drain transition region: n+ doping
- Drain extension region: n- doping
- Elongated resistor region: n+ doping

In this respect it is mentioned that a RF power transistor device in accordance with the invention can also be realized with a doping wherein compared to the type of doping given above an opposite type of doping is used.

It has to be noted that embodiments of the invention have been described with reference to different subject matters. In particular, some embodiments have been described with reference to apparatus type claims whereas other embodiments have been described with reference to method type claims. However, a person skilled in the art will gather from the above and the following description that, unless other notified, in addition to any combination of features belonging to one type of subject matter also any combination between features relating to different subject matters, in particular between features of the apparatus type claims and features of the method type claims is considered as to be disclosed with this application.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited

### BRIEF DESCRIPTION OF THE DRAWINGS

Figure 1 shows in a schematic view a cross section of a layout of a known RF-LDMOS device.
Figure 2a shows in an enlarged view a cross section of a layout of a further known RF-LDMOS device.
Figure 2b shows in an enlarged view a cross section of a layout of a RF-LDMOS device in accordance with a first embodiment of the invention.
Figure 3 shows by means of a voltage-current diagram a comparison between (a) the RF-LDMOS device shown in Figure 2b with (b) the known RF-LDMOS device shown in Figure 2a.
Figure 4a shows in an enlarged view a cross section of a layout of a further known RF-LDMOS device.
Figure 4b shows in an enlarged view a cross section of a layout of a RF-LDMOS device in accordance with a second embodiment of the invention.

### DESCRIPTION OF EMBODIMENTS

The illustration in the drawing is schematically. It is noted that in different figures, similar or identical elements or features are provided with the same reference signs or with reference signs, which are different from the corresponding reference signs only within the first digit. In order to avoid unnecessary repetitions elements or features which have already been elucidated with respect to a previously described embodiment are not elucidated again at a later position of the description.

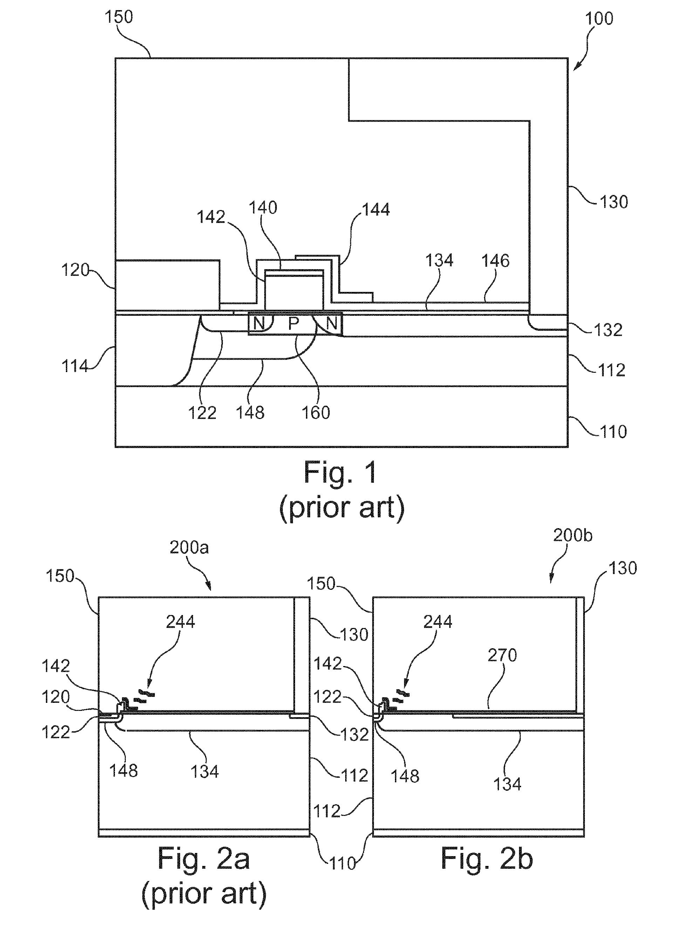

In order to allow for a better understanding of the invention described in this document first there will be described with reference to Figure 1 a layout of a known RF-LDMOS device and a typical behavior of such a device during some non exceptional operational conditions.

Figure 1 shows in a schematic view a cross section of a layout of a known RF-LDMOS device 100. The RF-LDMOS device 100 is built up on a substrate 110, which in the prior art example described here is a P-substrate. As can be seen from Figure 1, on top of the P-substrate 112 there is formed (a) an epitaxial grown P-type layer and (b) a connection region 114 which in the prior art example described here is a p-doped region. The connection region 114 provides an electrical contact between a source contact region 120 of the RF-LDMOS device 100 and the substrate 110 at the bottom of the RF-LDMOS device 100. Therefore, the p-doped connection region 114 is also called a P-sinker region.

As can be further seen from Figure 1, the RF-LDMOS device 100 comprises in accordance with usual MOS devices the above mentioned source contact region 120, a drain contact region 130, and a gate contact region 140. The source contact region 120, which is formed from a stacked metallic material, is connected to a source transition region 122. In the example given here, the source transition region 122 is a highly doped n-region (n+ region). The drain contact region 130, which is also formed from a stacked metallic material, is connected to a drain transition region 132. In the example given here, also the drain transition region 132 is a highly doped n-region (n+ region).

In the depicted layout of the RF-LDMOS device 100 there is further provided an elongated drain extension region 134 which consists of an n-doped layer. Thereby, the degree of n-doping of the elongated drain extension region 134 is smaller than the degree of doping of the drain transition region 132.

In between the source transition region 122 and the elongated drain extension region 134, embedded within the epitaxial grown P-type layer 112 and adjacent to the connection region 114, there is provided a p-doped base zone 148 which in accordance with the usual terminology of MOS devices is called a P-well or a backgate (zone).

Below the gate contact region 140 there is formed a gate transition region 142. In response to a suitable electric potential being applied to the gate contact region 140 there will, in accordance with the basic principles of MOS devices, develop a charge carrier channel between the gate transition region 142 and the base zone 148.

As can be further seen from Figure 1, the RF-LDMOS device 100 further comprises a protection layer 146 formed in particular over the elongated drain extension region 134, over the gate contact region 140, and the n+ doped source transition region 122. Further, an oxide layer or an oxide region 150 is formed over the source contact region 120, over the protection layer 146, and adjacent to the drain contact region 130.

Further, the RF-LDMOS device depicted in Figure 1 comprises a metallic shield arrangement 144. The shield arrangement 144 which in the depicted MOS device structure comprises one metallic shield being formed within the oxide region 150 is used for shielding an electric field acting on the gate contact region. Thereby, a strong electric field which may develop in particular between the drain contact region 130 and the gate contact region 140 and/or the gate transition region 142 if these regions are at highly different voltage levels may not be able to cause electrons "of", "at", or "within" the gate contact region 140 and/or the gate transition region 142 to enter the oxide layer 150. As a consequence, an electric charging of the oxide layer 150 can be effectively prevented.

In accordance with the basic physical property of MOS devices during operation of the RF-LDMOS device 100 there will develop an npn parasitic bipolar transistor 160. Thereby, the emitter of the parasitic bipolar transistor 160 is given by a part of the source transition region 122, the base of the parasitic bipolar transistor 160 is given by the top of the P-well/backgate zone 148, and the collector of the parasitic bipolar transistor 160 is given by a part of the elongated drain extension region 134. In Figure 1, the npn parasitic bipolar transistor 160 is indicated by a rectangle.

As has already been mentioned above, the known standard RF-LDMOS device 100 can go in a snapback mode if the parasitic bipolar transistor 160 of the RF-LDMOS device is triggered. This may mean that due to a strong electric field within the region of the parasitic bipolar transistor 160 the parasitic bipolar transistor 160 will go in a conductive state. Therefore, in response to such a triggering the Voltage Vds between the source contact region 120 and the drain contact region 130 will suddenly drop and the heat dissipation within the RF-LDMOS device 100 will decrease. Besides the decrease in the heat dissipation within the RF-LDMOS device 100 itself also the generated RF-power will decrease because of a snapback behavior.

It is pointed out that in the known standard RF-LDMOS device 100 such a snapback is typically destructive. This means that the respective RF-LDMOS device 100 will be irreversibly destroyed.

The snapback can be understood as normal bipolar behavior, when a breakdown occurs between collector and emitter while the base is not perfectly shorted with the emitter, but with a base resistor. According to this effect, when a high voltage difference is present between the source contact region 120 and the drain contact region 130, electrons and holes will be generated in response to this high voltage difference. The holes will then travel to the P-well 148 and the electrons will travel to the drain transition region 132 respectively to the drain contact region 130. The holes will flow through the base resistor region, giving a voltage drop across this resistor region and the Voltage Vbe between Base and Emitter will increase. As a consequence, the RF-LDMOS device 100 will exhibit a Breakdown between Collector and Emitter while the base is connected with a Resistance to the emitter (so called BVCER breakdown) which will result in a snapback characteristic.

It is pointed out that this "normal" bipolar behavior will be further accelerated in an LDMOS device because of the low doping level in the drain extension region: The BVCER breakdown is generating a current respectively the density of charge carriers flowing within the RF-LDMOS device 100 will be strongly increased. In case of a very strong current the density of the charge carriers will be larger than the density of doping. This is known as the Kirk effect. This results in spatial widening in particular in the P-well 148 and in the low doped elongated drain extension region 134. This spatial widening will increase the current further with a very inhomogeneous current. Consequence is that if the parasitic bipolar transistor 160 is triggered, a current crowding will occur at least at one point within the RF-LDMOS device 100 and the device 100 will be irreversibly destroyed.

Figures 2a and 2b show in an enlarged view a comparison between (a) a RF-LDMOS device 200b in accordance with a first embodiment of the invention and (b) a further known RF-LDMOS device 200a. Apart from different spatial proportions in the drawing the further known RF-LDMOS device 200a differs from the known RF-LDMOS device 100 depicted in Figure 1 only in that the shield arrangement 114 comprising only one shield is replaced by a shield arrangement 244 comprising three shields.

As can be seen from a comparison between the Figures 2b and 2a the RF-LDMOS device 200b differs from the known RF-LDMOS device 200a in that on top of or embedded within the elongated drain extension region 134 there is formed an elongated resistor region 270. The elongated resistor region can also be called a spreading resistor 270, because it yields a spatial spreading of the current flowing within the elongated drain extension region 134. As can be understood from the above given explanation of the Kirk effect this spatial spreading results in that the effect of current crowding will be diminished and the RF-LDMOS device 200b can more easily survive the occurrence of a snapback effect. According to the embodiment described here the elongated resistor region 270 respectively the spreading resistor 270 are made from a highly n doped material.

Descriptive speaking, in the structure given in Figure 2b a long N+ resistor 270 is included in the design at the drain contact. This resistor 270 improves the spatial current spreading. In the structure given in Figure 2b the resistor 270 has a length (in horizontal direction) of about 9.5 µm. However, it is mentioned that the optimal length of the n+ spreading resistor 270 may depend on the degree of doping and that depending on the degree of doping in particular of the elongated drain extension region 134 other optimal lengths of the n+ spreading resistor 270 may be found as to be optimal.

In this respect it is mentioned that it is also possible to form the spreading resistor (270) in the elongated drain extension region 134 at the gate side instead of at the side of the drain contact region 130. This means that the spreading resistor (270) starts at the gate transition region 142 and extends towards but not until the drain contact region 130.

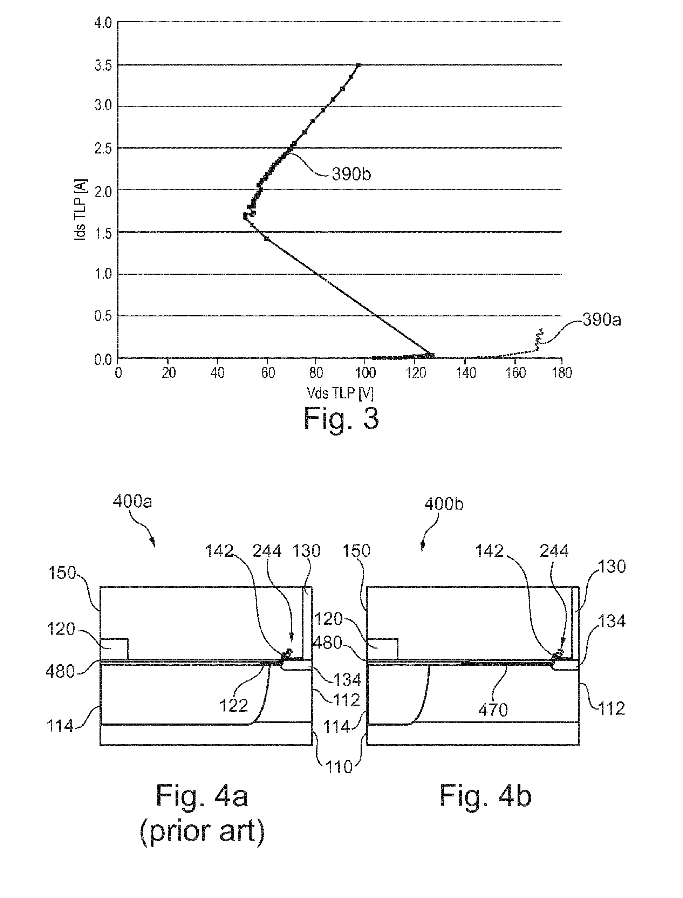

Figure 3 shows in a voltage-current diagram the characteristic curves of (a) the known RF-LDMOS device 200a shown in Figure 2a and (b) the RF-LDMOS device 200b shown in Figure 2b. At the axis of abscissa the Drain-Source Voltage Vds of the respective RF-LDMOS device is plotted and at the axis of ordinate the Drain-Source Current Ids of the respective RF-LDMOS device is plotted. Reference numeral 390a denominates the characteristic curve being assigned to the RF-LDMOS device 200a. Reference numeral 390b denominates the characteristic curve being assigned to the RF-LDMOS device 200b.

The curves 390a and 390b have been experimentally obtained by a sequence of transmission line pulse. This means that sequentially a series of pulses with increasing Drain-Source Voltage has been acted on the respective RF-LDMOS device 200a, 200b. In both cases the RF-LDMOS device 200a, 200b have been measured until a destructive failure.

As can be seen from Figure 3, the characteristic curve 390a starts at a Drain-Source Voltage Vds of about 145 V and a Drain-Source Current Ids of 0 A. Increasing the Drain-Source Voltage Vds up to about 150 V does not result into a significantly increased Drain-Source Current Ids. Starting from about 150 V the Drain-Source Current Ids increases approximately linearly with increasing Drain-Source Voltage Vds. Therefore, the Drain-Source Voltage Vds of about 150 V represents the so called Breakdown Voltage BVds between Drain and Source of the RF-LDMOS device 200a. At a Drain-Source Voltage Vds of about 170 V the Drain-Source Current Ids dramatically increases up to a value of about 0.35 A at which the known RF-LDMOS device 200a is getting damaged.

The characteristic curve 390b being assigned to the RF-LDMOS device 200b starts with at a Drain-Source Voltage Vds of about 103 V and a Drain-Source Current Ids of 0 A. Increasing the Drain-Source Voltage Vds up to about 115 V does not result into a significantly increased Drain-Source Current Ids. Starting from about 115 V the Drain-Source Current Ids increases approximately linearly with increasing Drain-Source Voltage Vds. Therefore, in this case the Drain-Source Voltage Vds of about 115 V represents the Breakdown Voltage BVds between Drain and Source of the RF-LDMOS device 200b. At a Drain-Source Voltage Vds of about 128 V the Drain-Source Current Ids has reached a value of about 0.05 A. At this point a snapback behavior occurs which causes (a) the Drain-Source Voltage Vds to decrease to about 50 V and (b) the Drain-Source Current Ids to increase up to approximately 1.7 A. If at this point one again increases the Drain-Source Voltage Vds from about 50 V up to 97 V the characteristic curve 390b of the RF-LDMOS device 200b shows approximately an ohmic behavior where with increasing Drain-Source Voltage Vds the Drain-Source Current Ids increases approximately linearly from 1.7 A to a value of about 3.5 A at which the RF-LDMOS device 200b is getting damaged.

In this respect it is mentioned that the maximum power (i.e. the product of the Drain-Source Voltage Vds with the Drain-Source Current Ids) obtained in the described TLP measurements is a good measure for the RF ruggedness of the respective RF-LDMOS device 200a, 200b. Therefore, the RF ruggedness for the RF-LDMOS device 200b showing the extensive snapback behavior is superior as compared to the RF ruggedness of the known RF-LDMOS device 200a.

In this respect it is noted that the Breakdown Voltage BVds between Drain and Source of the RF-LDMOS device 200b of about 115 V may be too low for certain applications. However, the Breakdown Voltage BVds may be increased by choosing a somewhat longer length of the elongated drain extension region (at the cost of an increased ohmic resistance Rds between Drain and Source.

Figures 4a and 4b show in an enlarged view a comparison between (a) a RF-LDMOS device 400b in accordance with a second embodiment of the invention and (b) the further known RF-LDMOS device 200a, which is now denominated with reference numeral 400a. Apart from different spatial proportions in the drawing the further known RF-LDMOS device 400a differs from the known RF-LDMOS device 100 depicted in Figure 1 only in that (a) the shield arrangement 114 comprising only one shield is replaced by the shield arrangement 244 comprising three shields and (b) the source contact region 120 is connected to an elongated P+ backgate 480.

As can be seen from a comparison between the Figures 4b and 4a, the RF-LDMOS device 400b differs from the known RF-LDMOS device 400a in that an elongated resistor region 470 is formed between the gate transition region 142 and source contact region 120. According to the embodiment described here the elongated resistor region 470, which in accordance with the elongated resistor region 270 shown in Figure 2b also acts as a spreading resistor, comprises an n+ doped material and extends from the gate transition region 142 towards but not completely to the source contact region 120.

Descriptive speaking, it is not necessary to place the n+ spreading resistor between the drain contact region 130 and the gate transition region 142 as depicted in Figure 2b. A similar effect of current spreading may also be realized if the spreading resistor 470 is placed at the source side of the RF-LDMOS device 400b. This gives an emitter resistor for the parasitic bipolar transistor, which will improve the current spreading.

It should be noted that the term "comprising" does not exclude other elements or steps and "a" or "an" does not exclude a plurality. Also elements described in association with different embodiments may be combined. It should also be noted that reference signs in the claims should not be construed as limiting the scope of the claims.

In order to recapitulate the above described embodiments of the present invention one can state:

In a RF power transistor device such as a RF-LDMOS device a parasitic bipolar transistor is present between the source of the device and the drain of the device. If in particular due to mismatch of the wave resistance or the cable impedance at the output side of the device a VSWR-ruggedness event occurs, high electrical fields are present in the device and the parasitic bipolar transistor can be triggered. In a diagram where at the axis of abscissa the Drain-Source Voltage Vds of the device and at the axis of ordinate the Drain-Source Current Ids is plotted this triggering will result in a so called snapback characteristic at the Drain of the device. This triggering of the parasitic bipolar transistor is normally destructive.

With a special layout/processing of the device as presented in this document a highly doped current spreading resistor region is added or provided in the design of a lower doped drain extension region connecting at least partially the Drain of the device with the parasitic bipolar transistor of the device. Thereby, the current spreading resistor region may act as a series resistance connected between the Drain and the parasitic bipolar transistor. The current spreading resistor region may be located at the side of the Drain of the device and/or at the side of the gate of the parasitic bipolar transistor. With this modification the probability that the device can survive the triggering of the parasitic bipolar transistor is highly increased. If the device and in particular a RF-LDMOS device survives such a snapback, inter alia the following advantages arise:
(a) The (non destructive) snapback will decrease the power dissipation within the (RF-LDMOS) device during a VSWR ruggedness event respectively a snapback event, thus giving a better (intrinsic) VSWR. ruggedness. As a result, the thermal behavior of the device will be less critical.
(b) The snapback will decrease the generated RF-power during a VSWR ruggedness event, which will protect the (RF-LDMOS) device.
(c) Know precautions or measures in the semiconductor design of the (RF-LDMOS) device in order to prevent a triggering of the parasitic bipolar transistor can be reduced, which typically leads to a better RF-performance.
(c) The described (RF-LDMOS) device with the (non destructive) snapback characteristic will function with a much smaller drain extension region, which may give (i) a much lower ohmic resistance (Rds) between the Drain and the Source of the device and/or (ii) a decrease in the output capacitance. A lower value for the length of the drain extension region may be determined by a breakdown voltage (BVds) between the Drain and the Source of the device.
(d) The current spreading resistor region yielding the increased VSWR ruggedness can be realized by means of standard semiconductor (diffusion) processing of a (RF-LDMOS) device.

In this respect it is mentioned that with the described special layout/processing of the (RF-LDMOS) device a typically unwanted increase of the capacitance at the output of the (RF-LDMOS) device might occur. However, this may be compensated in a beneficial manner by choosing a smaller drain extension region.

### Reference Numerals:

- 100: known RF-LDMOS device
- 110: P-substrate
- 112: epitaxial grown P-type layer
- 114: connection region / P-sinker region
- 120: source contact region
- 122: source transition region / n+ region
- 130: drain contact region
- 132: drain transition region / n+ region
- 134: elongated drain extension region / region n- region
- 140: gate contact region
- 142: gate transition region
- 144: shield arrangement (one shield)
- 146: protection layer
- 148: base zone / P-well / backgate
- 150: oxide layer / oxide region
- 160: npn parasitic bipolar transistor

- 200a: known RF-LDMOS device
- 200b: RF-LDMOS device in accordance with the invention (1st embodiment)
- 244: shield arrangement (three shields)
- 270: elongated resistor region / n+ spreading resistor

- 390a: characteristic curve of known RF-LDMOS device
- 390b: characteristic curve of RF-LDMOS device in accordance with the invention (1st embodiment)

- 400a: known RF-LDMOS device
- 400b: RF-LDMOS device in accordance with the invention (2nd embodiment)
- 470: elongated resistor region / n+ spreading resistor
- 480: P+ backgate

## Claims

1. A Radio Frequency power transistor device (200b, 400b) comprising:
a substrate (110),
a source contact region (120) formed over the substrate (110),
a gate contact region formed (140) over the substrate (110),
a drain contact region (130) formed over the substrate (110),
a parasitic bipolar transistor (160) given between the substrate (110) and the gate contact region (140),
an elongated drain extension region (134) being connected to the drain contact region (130) and extending at least partially towards the parasitic bipolar transistor (160), and
an elongated resistor region (270, 470) being arranged between the source contact region (120) and the drain contact region (130), wherein the elongated resistor region (270, 470) extends partially between the source contact region (120) and the drain contact region (130).

2. The Radio Frequency power transistor device (200b, 400b) as set forth in the preceding claim, wherein
the elongated resistor region (270, 470) comprises a sheet resistance of less than 400 Ohm/square, preferably of less than 300 Ohm/square and more preferably less than 200 Ohm/square.

3. The Radio Frequency power transistor device (200b, 400b) as set forth in any one of the preceding claims, further comprising
a connection region (114) extending between the substrate (110) and the source contact region (120).

4. The Radio Frequency power transistor device (200b, 400b) as set forth in any one of the preceding claims, further comprising
a base zone (148) being formed between the gate contact region (140) and the substrate (110), wherein the base zone (148) is assigned to the parasitic transistor (160).

5. The Radio Frequency power transistor device (200b, 400b) as set forth in any one of the preceding claims, further comprising
an oxide layer (150) formed over at least the gate contact region (140).

6. The Radio Frequency power transistor device (200b, 400b) as set forth in the preceding claim, further comprising
a shield arrangement (244), which is formed within the oxide layer (150) and which is configured for shielding an electric field acting on the gate contact region (140).

7. The Radio Frequency power transistor device (200b, 400b) as set forth in any one of the preceding claims, wherein
the source contact region (120), the gate contact region (140) and/or the drain contact region (130) comprise a metallic material.

8. The Radio Frequency power transistor device (200b, 400b) as set forth in any one of the preceding claims, further comprising
a source transition region (122) connecting the source contact region (120) with the parasitic bipolar transistor (160) and
a drain transition region (132) connecting the drain contact region (130) with the elongated drain extension region (134), wherein both the source transition region (122) and the drain transition region (132) are doped regions.

9. The Radio Frequency power transistor device (200b) as set forth in any one of the preceding claims 1 to 8, wherein
the elongated resistor region (270) (i) is formed between the drain contact region (130) and the parasitic bipolar transistor (160) and (ii) is arranged adjacent to the elongated drain extension region (134), wherein with respect to their longitudinal axes the elongated resistor region (270) and the elongated drain extension region (134) are arranged parallel to each other.

10. The Radio Frequency power transistor device (200b) as set forth in the preceding claim, wherein
both the elongated drain extension region (134) and the elongated resistor region (270) are doped regions of the same type of doping, wherein the level of doping of the elongated resistor region (270) is larger than the level of doping of the elongated drain extension region (134).

11. The Radio Frequency power transistor device (200b) as set forth in any one of the preceding claims 9 to 10, wherein
a length of the elongated resistor region (270) is at least 10%, preferably at least 15%, and more preferably at least 20% of the distance between the drain contact region (130) and the gate contact region (140).

12. The Radio Frequency power transistor device (200b) as set forth in any one of the preceding claims 9 to 11, wherein
the elongated resistor region (270) has a length of between 0.5 µm and 15 µm, preferably between 1 µm and 12 µm, and more preferably between 1.5 µm and 11 µm.

13. The Radio Frequency power transistor device (400b) as set forth in the preceding claim 8, wherein
the elongated resistor region (470) (i) is formed between the source contact region (120) and the parasitic bipolar transistor (160) and (ii) is arranged adjacent to the source transition region (122).

14. The Radio Frequency power transistor device (400b) as set forth in the preceding claim, wherein
the elongated resistor region (470) has a length of between 0.5 µm and 15 µm, preferably between 1 µm and 12 µm, and more preferably between 1.5 µm and 12 µm.

15. A method for manufacturing a Radio Frequency power transistor device (200b, 400b), in particular for manufacturing a Radio Frequency power transistor device (200b, 400b) as set forth in any one of the preceding claims, the method comprising
providing a substrate (110),
forming over the substrate (110) (i) a source contact region (120), (ii) a gate contact region (140), and (iii) a drain contact region (130) such that a parasitic bipolar transistor (160) is given between the substrate (110) and the gate contact region (140),
forming an elongated drain extension region (134) being connected to the drain contact region (130) and extending at least partially towards the parasitic bipolar transistor (160), and
forming an elongated resistor region (270, 470) being arranged between the source contact region (120) and the drain contact region (130), wherein the elongated resistor region (270, 470) extends partially between the source contact region (120) and the drain contact region (130).
